# EUROPEAN PATENT APPLICATION

(11) **EP 2 530 834 A1**
(43) Date of publication of application: **05.12.2012**
(21) Application number: 12167553.2
(22) Date of filing: 10.05.2012
(51) Int. Cl.: H03F 1/56, H03F 3/193, H03F 3/72, H04B 1/44

(54) **RF amplifier with open circuit input off-state**

(30) Priority: 31.05.2011 US 201113149618
(71) Applicant: Raytheon Company, Waltham, MA 02451-1449 (US)
(72) Inventor: Fast, Bryan, Garland, TX 75040 (US); Heston, David D., Dallas, TX 75231-1523 (US); Hawkins, Michael G., Plano, TX 75075-3138 (US); Helm, Brian P., Murphy, TX 75094-4297 (US)
(74) Representative: Witte, Weller & Partner

(57) **Abstract**

An amplifier (10) including an amplifier transistor, and a switch transistor, wherein the amplifier is configured to be switched on and off by controlling bias voltages of the transistors.

## Description

### BACKGROUND

The present invention relates to the field of amplifiers.

Antennas and antenna arrays may be designed to have the ability to operate in both a transmit mode and a receive mode. Transmit/receive (TR) systems associated with such antennas and antenna arrays typically have two electrical paths, one path for when the TR system is in a receive mode, and another path for when the TR system is in a transmit mode. Accordingly, conventional TR chips require a switch network to implement bidirectional operation. The switch network enables TR systems to both allow an electrical signal, such as a transmit signal, produced by the TR system to be transmitted to, and radiated by, the antenna, and also allow information detected by the antenna to be sent via an electrical signal, such as a receive signal, to be analyzed by the TR system.

A TR system may include a 3-port circulator for low-loss/high-power applications, which may be coupled at a first port to an antenna, or antenna array, at a second port to the input of a receive amplifier, and at a third port to the output of a transmit amplifier. In such a TR system, the output of the receive amplifier and the input of the transmit amplifier can be coupled to a single pole, double throw static switch. Accordingly, the amplifiers may be alternately coupled between the antenna and the remainder of the TR system via operation of the switch and the circulator.

Alternatively, the circulator may be replaced by a second single pole, double throw static switch, which allows the antenna to be alternately coupled to the input of the receive amplifier and the output of the transmit amplifier. Accordingly, when the TR system is operating in a transmit mode, the switches operate to electrically couple the antenna to the remainder of the system via the transmit amplifier, while electrically isolating, or decoupling, the receive amplifier from the antenna and the rest of the system, so that the system processor may deliver a transmit signal to the antenna. When the TR system is operating in a receive mode, the switches flip, thereby coupling the antenna to the rest of the TR system via the receive amplifier while electrically isolating the transmit amplifier from the antenna and the rest of the system, so that the system processor may receive a receive signal detected by the antenna.

Loss due to conventional switch networks, directly effects the noise performance of a receive amplifier located in the electrical path used for the receive mode of the TR system. Furthermore, such loss also effects the performance of a transmit amplifier used in the electrical path for the transmit mode, thereby contributing to degradation of the range of the antenna and reducing the capability of the TR system.

### SUMMARY

Embodiments of the present invention integrate tuning elements, capacitors, and transistors of the input matching network of transmit and receive amplifiers with those of a switch to achieve the functions of, and therefore, obviate the need for, switches and circulators in TR systems by allowing transmit and receive amplifiers to operate as signal switches. By removing the need for switches or circulators, and thereby reducing the number of electronic elements required to achieve bidirectional RF capability in the TR system, loss due to a switch network is reduced, while the cost to fabricate the TR system, as well as the amount of space required by the TR system, are also reduced. Furthermore, embodiments of the present invention provided an amplifier that may be operated as a signal switch.

In accordance with one exemplary embodiment of the present invention, there is provided an antenna system including a system processor, an antenna element, a receive amplifier including an input coupled to the antenna element, and an output coupled to the system processor, and a transmit amplifier including an input coupled to the output of the receive amplifier, and an output coupled to the input of the receive amplifier.

The input of the receive amplifier may be directly coupled to the output of the transmit amplifier, and the output of the receive amplifier may be directly coupled to the input of the transmit amplifier.

The system processor may be configured to receive a receive signal from the antenna element via the receive amplifier, and may be configured to transmit a transmit signal to the antenna element via the transmit amplifier.

The inputs of the receive amplifier and transmit amplifier may each include a switch transistor.

A gate of each switch transistor may be coupled to the system processor, each switch transistor may be configured to operate as a signal switch, and the system processor may be configured to control each switch transistor in accordance with a transmit mode and a receive mode of the antenna system.

The receive amplifier and the transmit amplifier may be configured to alternately allow electrical signals to pass therethrough.

The outputs of the receive amplifier and the transmit amplifier may each include an amplifier transistor.

The system processor may be coupled to gates of the amplifier transistors and may be configured to control a gate bias voltage of the amplifier transistors to control the amplifier transistors in accordance with a transmit mode or a receive mode of the antenna system.

The receive amplifier and the transmit amplifier may each include a plurality of tuning elements coupled to transmission lines.

One or more of the tuning elements may be configured to be tunable to adjust impedance of the amplifiers.

One or more of the tuning elements may be configured to be operated as a quarter-wave shunt switch.

The receive amplifier and the transmit amplifier may include a monolithic microwave integrated circuit component.

The receive amplifier may be a low-noise amplifier, and the transmit amplifier may be a high-power amplifier.

The outputs of the receive amplifier and transmit amplifier may each include an amplifier transistor, the inputs of the receive amplifier and transmit amplifier may each include a switch transistor, a gate of the amplifier transistor of the receive amplifier may be coupled to an electrode of the switch transistor of the receive amplifier, and a gate of the amplifier transistor of the transmit amplifier may be coupled to an electrode of the switch transistor of the transmit amplifier.

The gates of the switch transistors may be coupled to the system processor, which may be configured to manipulate impedance of the amplifiers by sending control signals to the switch transistors in accordance with either a transmit mode and a receive mode of the antenna system.

In accordance with another exemplary embodiment of the present invention, there is provided an antenna system including a system processor configured to send a transmit signal and receive a receive signal, an antenna element configured to radiate the transmit signal and detect the receive signal, a receive amplifier configured to amplify the receive signal and including an input coupled to the antenna element and including a switch transistor, and an output coupled to the system processor and including an amplifier transistor coupled to the switch transistor, and a transmit amplifier configured to amplify the transmit signal and including an input coupled to the output of the receive amplifier and including a switch transistor, and an output coupled to the input of the receive amplifier and including an amplifier transistor coupled to the switch transistor of the transmit amplifier, wherein the system processor is configured to alternately operate the amplifiers as signal switches according to control signals delivered to gates of the switch transistors.

In accordance with yet another exemplary embodiment of the present invention, there is provided an amplifier including an amplifier transistor, and a switch transistor, wherein the amplifier is configured to be switched on and off by controlling bias voltages of the transistors.

The transistors may be configured to have the bias voltages controlled by a control signal delivered to a gate of the switch transistor.

An electrode of the switch transistor may be coupled to a gate of the amplifier transistor, and a gate signal may be sent to the gate of the amplifier transistor in accordance with the control signal.

Accordingly, embodiments of the present invention allow for TR systems of improved performance and reduced size and cost and for an amplifier that may be operated as a switch.

### BRIEF DESCRIPTION OF THE DRAWINGS

The accompanying drawings, together with the specification, illustrate exemplary embodiments of the present invention, and, together with the description, serve to explain aspects of embodiments of the present invention. The above and other features and aspects of the present invention will become more apparent by describing in detail exemplary embodiments thereof with reference to the attached drawings, in which:
FIG. 1 is a circuit diagram of a TR system including transmit and receive amplifiers according to an embodiment of the present invention;
FIG. 2 is a circuit diagram depicting a combination of a switch and the input of one of the amplifiers of a TR system; and
FIG. 3 is a circuit diagram depicting an amplifier input of an amplifier according to an embodiment of the present invention.

### DETAILED DESCRIPTION

A switch used in a TR chip of an electronically scanned antenna array system may be implemented as a separate component from the amplifier design of the transmit and receive amplifiers used in the TR system. Accordingly, switches are often designed in isolation from the design of the amplifier, and integrated only after the switches are individually optimized.

Benefit may be realized by designing the switches to be part of the same circuit that includes the amplifiers used to amplify the transmit signals and receive signals, and by merging various elements of corresponding switches and amplifiers, thereby enhancing performance of the antenna array system with minimal disadvantage.

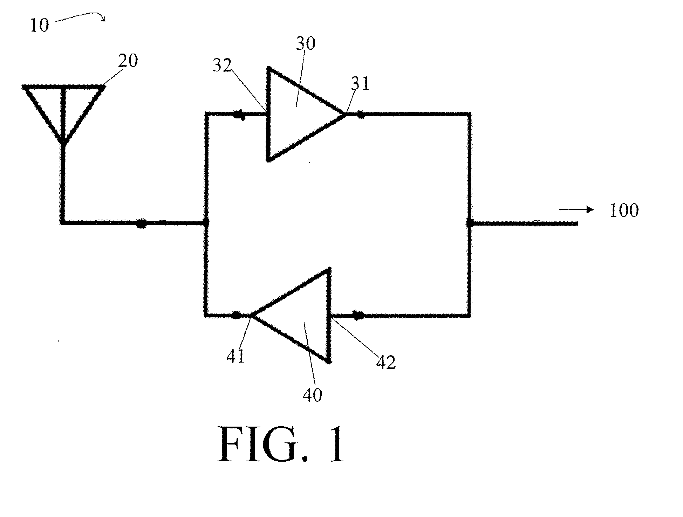

Referring to FIG. 1, a TR system 10 according to an embodiment of the present invention is shown. The TR system 10 includes an antenna 20 coupled to both an input 32 of a receive amplifier 30, and an output 41 of a transmit amplifier 40. Although a single antenna 20 is shown, the antenna 20 may also represent a plurality of antennas or antenna elements, as in an antenna array. An output 31 of the receive amplifier 30 and an input 42 of the transmit amplifier 40 are then coupled to each other and to the remainder of the TR system 10, the specific details of components of which, such as the system processor 100, are not shown, as such details will be known to one of ordinary skill in the art. Furthermore, the two amplifiers 30, 40 may be incorporated into a single TR MMIC component.

The receive amplifier 30 may operate as a low-noise amplifier (LNA) while the TR system 10 is in a receive mode. While in the receive mode, an impedance of a transmit path through the transmit amplifier 40 is high, and the transmit path operates as an "open" circuit. In order to match impedance with an input of the receive amplifier 30, TR switch parasitics may be utilized at the input 32 of the receive amplifier 30. When the TR system 10 of the present embodiment is operated in a transmit mode, the transmit amplifier 40 may operate as a high-power amplifier. While in the transmit mode, impedance of a receive path through the receive amplifier 30 is high, and the receive path operates as an "open" circuit.

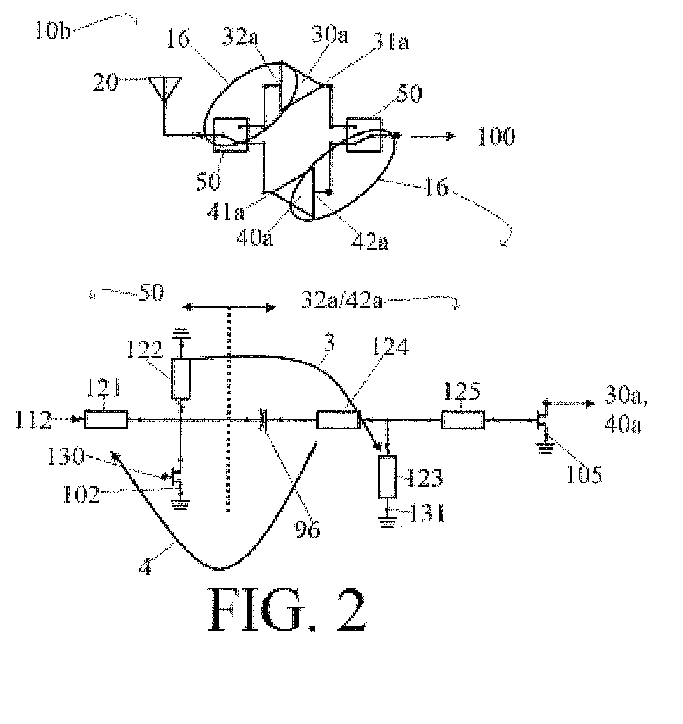

FIG. 2 depicts the circuitry of a TR system 10b wherein the input 32a, 42a of either the receive amplifier 30a or the transmit amplifier 40a (shown on the right) is coupled to the circuitry of the single pole, double throw static switch 50 (shown on the left). The combination of the input 32a, 42a and the switch 50 is depicted by reference character 16. The combination 16 includes tuning elements 121, 122, 123, 124, and 125, with tuning element 121 acting as a quarter-wave shunt switch. The combination 16 also includes a capacitor 96, a switch transistor 102, and a transistor 105. Transistor 105 is coupled to the remainder of the amplifier 30a, 40a. The switch 50 of the circuit is operated by switch transistor 102, which is operated by a TR control signal delivered to a gate of the switch transistor 102.

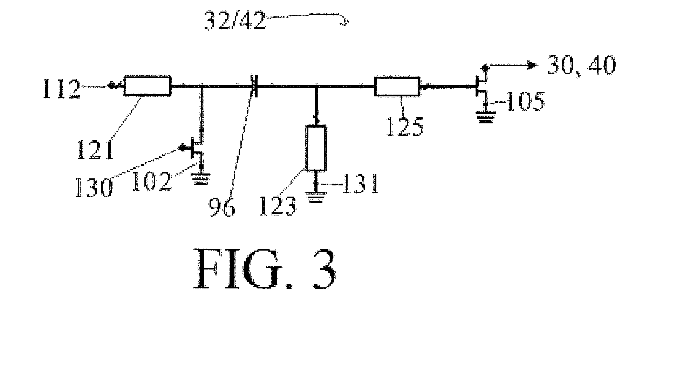

The arrows 3 and 4 of FIG. 2 depict how the functions of some of the various indicated elements of the switch 50 and the input 32a, 42a of the amplifier 30a, 40a may be achieved by the elements of the input 32, 42 of the amplifier 30, 40 of the embodiment of the present invention shown in FIG. 3. For example, arrow 3 depicts that the functions of the tuning elements 122 and 123 of the combination 16 shown in FIG. 2 may be achieved by the tuning element 123 of input 32, 42 of the amplifier 30, 40 of the embodiment of the present invention depicted in FIG. 3, while arrow 4 depicts that the functions of tuning elements 121 and 124 of the combination shown in FIG. 2 may be achieved by the tuning element 121 of input 32, 42 of the amplifier 30, 40 of the embodiment of the present invention depicted in FIG. 3.

FIG. 3 depicts the input 32, 42 of the receive amplifier 30 or the transmit amplifier 40 according to an embodiment of the present invention. The input 32, 42 includes tuning element 121 and switch transistor 102, which may be operated together as a quarter-wave shunt switch. The input 32, 42 also includes the capacitor 96, the switch transistor 102, and the transistor 105, wherein transistor 105 is coupled to the remainder of the amplifier 30, 40.

Referring to FIG. 3, and referring to the input 32 of the receive amplifier 30, when the receive amplifier 30 is operational, and the TR system 10 is in a receive mode, the impedance measured from line 112 is a nominal impedance, such as, for example, 50 ohms, and an electrical signal, such as a receive signal detected by the antenna 20 and delivered to the system processor 100 of the TR system 10. When the TR system 10 is in a transmit mode, the impedance measured from line 112 is high, e.g., an "open-circuit" impedance, and electrical signals along the receive path are effectively blocked by the receive amplifier 30.

Similarly, when the TR system 10 is in a transmit mode, the impedance measured from line 112 of the transmit amplifier 40 is a nominal impedance, allowing an electrical signal to pass therethrough, such as a transmit signal from the system processor 100 to the antenna 20. When the TR system is in a receive mode, the impedance of line 112 of the transmit amplifier 40 is high, and electrical signals along the transmit path are effectively blocked by the transmit amplifier 40.

The switch transistor 102 may be operated by a TR control signal delivered to a gate of the switch transistor 102, which may be a digital signal sent via the TR state line 130, thereby causing the switch transistor 102 to operate as a signal switch. Furthermore, an electrode of the switch transistor 102 may be coupled to a gate of an amplifier transistor at an output side 31, 41 of the amplifier 30, 40, according to embodiments of the present invention, whereby operation of the switch transistor 102 delivers a gate signal to the amplifier transistor via the gate line 131. The switch network parasitics of the inputs 32 and 42 may be designed to effectively match the topology of the amplifiers 30 and 40.

Accordingly, benefit may be realized by an amplifier that may be operated as a signal switch and by a TR system that obviates the need for switch or circulator circuitry by utilizing design of receive and transmit amplifiers of embodiments of the present invention.

While the present invention has been particularly shown and described with reference to exemplary embodiments thereof, it will be understood by those of ordinary skill in the art that features of different embodiments may be combined to form further embodiments, and that various changes in form and details may be made therein, without departing from the spirit and scope of the present invention as defined by the following claims and their equivalents.

Further, invention comprises the following embodiments disclosed in the form of clauses for the sake of conciseness:
Clause 1. An antenna system comprising:
   a system processor;
   an antenna element;
   a receive amplifier comprising:
      an input coupled to the antenna element; and
      an output coupled to the system processor; and
   a transmit amplifier comprising:
      an input coupled to the output of the receive amplifier; and
      an output coupled to the input of the receive amplifier.
Clause 2. The antenna system of clause 1, wherein the input of the receive amplifier is directly coupled to the output of the transmit amplifier, and wherein the output of the receive amplifier is directly coupled to the input of the transmit amplifier.
Clause 3. The antenna system of clause 1 or 2, wherein the system processor is configured to receive a receive signal from the antenna element via the receive amplifier, and is configured to transmit a transmit signal to the antenna element via the transmit amplifier.
Clause 4. The antenna system of any of clauses 1 to 3, wherein the inputs of the receive amplifier and transmit amplifier each comprise a switch transistor.
Clause 5. The antenna system of clause 4, wherein:
   a gate of each switch transistor is coupled to the system processor;
   each switch transistor is configured to operate as a signal switch; and
   the system processor is configured to control each switch transistor in accordance with a transmit mode and a receive mode of the antenna system.
Clause 6. The antenna system of clause 5, wherein the receive amplifier and the transmit amplifier are configured to alternately allow electrical signals to pass therethrough.
Clause 7. The antenna system of any of clauses 1 to 6, wherein the outputs of the receive amplifier and the transmit amplifier each comprise an amplifier transistor.
Clause 8. The antenna system of clause 7, wherein the system processor is coupled to gates of the amplifier transistors and is configured to control a gate bias voltage of the amplifier transistors to control the amplifier transistors in accordance with a transmit mode or a receive mode of the antenna system.
Clause 9. The antenna system of any of clauses 1 to 8, wherein the receive amplifier and the transmit amplifier each comprise a plurality of tuning elements coupled to transmission lines.
Clause 10. The antenna system of clause 9, wherein one or more of the tuning elements are configured to be tunable to adjust impedance of the amplifiers.
Clause 11. The antenna system of clause 9, wherein one or more of the tuning elements are configured to be operated as a quarter-wave shunt switch.
Clause 12. The antenna system of any of clauses 1 to 11, wherein the receive amplifier and the transmit amplifier comprise a monolithic microwave integrated circuit component.
Clause 13. The antenna system of any of clauses 1 to 12, wherein the receive amplifier is a low-noise amplifier, and the transmit amplifier is a high-power amplifier.
Clause 14. The antenna system of any of clauses 1 to 13, wherein:
   the outputs of the receive amplifier and transmit amplifier each comprise an amplifier transistor;
   the inputs of the receive amplifier and transmit amplifier each comprise a switch transistor;
   a gate of the amplifier transistor of the receive amplifier is coupled to an electrode of the switch transistor of the receive amplifier; and
   a gate of the amplifier transistor of the transmit amplifier is coupled to an electrode of the switch transistor of the transmit amplifier.
Clause 15. The antenna system of clause 14, wherein the gates of the switch transistors are coupled to the system processor, which is configured to manipulate impedance of the amplifiers by sending control signals to the switch transistors in accordance with either a transmit mode and a receive mode of the antenna system.
Clause 16. An antenna system comprising:
   a system processor configured to send a transmit signal and receive a receive signal;
   an antenna element configured to radiate the transmit signal and detect the receive signal;
   a receive amplifier configured to amplify the receive signal and comprising:
      an input coupled to the antenna element and comprising a switch transistor; and
      an output coupled to the system processor and comprising an amplifier transistor coupled to the switch transistor; and
   a transmit amplifier configured to amplify the transmit signal and comprising:
      an input coupled to the output of the receive amplifier and comprising a switch transistor; and
      an output coupled to the input of the receive amplifier and comprising an amplifier transistor coupled to the switch transistor of the transmit amplifier, wherein the system processor is configured to alternately operate the amplifiers as signal switches according to control signals delivered to gates of the switch transistors.
Clause 17. An amplifier comprising:
   an amplifier transistor; and
   a switch transistor, wherein the amplifier is configured to be switched on and off by controlling bias voltages of the transistors.
Clause 18. The amplifier of clause 17, wherein the transistors are configured to have the bias voltages controlled by a control signal delivered to a gate of the switch transistor.
Clause 19. The amplifier of clause 17 or 18, wherein an electrode of the switch transistor is coupled to a gate of the amplifier transistor, and wherein a gate signal is sent to the gate of the amplifier transistor in accordance with the control signal.

## Claims

1. An antenna system (10) comprising:
a system processor (100);
an antenna element (20);
a receive amplifier (30) comprising:
an input (32) coupled to the antenna element (20); and
an output (31) coupled to the system processor (100); and
a transmit amplifier (40) comprising:
an input (42) coupled to the output (31) of the receive amplifier (30); and
an output (41) coupled to the input (32) of the receive amplifier (30).

2. The antenna system of claim 1, wherein the input (32) of the receive amplifier (30) is directly coupled to the output (41) of the transmit amplifier (40), and wherein the output (31) of the receive amplifier (30) is directly coupled to the input (42) of the transmit amplifier (40).

3. The antenna system of claim 1 or 2, wherein the system processor (100) is configured to receive a receive signal from the antenna element (20) via the receive amplifier (30), and is configured to transmit a transmit signal to the antenna element (20) via the transmit amplifier (40).

4. The antenna system of any of claims 1 to 3, wherein the inputs (32, 42) of the receive amplifier (30) and transmit amplifier (40) each comprise a switch transistor (102).

5. The antenna system of claim 4, wherein:
a gate of each switch transistor is coupled to the system processor (100);
each switch transistor (102) is configured to operate as a signal switch; and
the system processor (100) is configured to control each switch transistor (102) in accordance with a transmit mode and a receive mode of the antenna system (20).

6. The antenna system of claim 5 wherein the receive amplifier (30) and the transmit amplifier (40) are configured to alternately allow electrical signals to pass therethrough.

7. The antenna system of any of claims 1 to 6, wherein the outputs of the receive (30) amplifier and the transmit amplifier (40) each comprise an amplifier transistor.

8. The antenna system of claim 7, wherein the system processor (100) is coupled to gates of the amplifier transistors and is configured to control a gate bias voltage of the amplifier transistors to control the amplifier transistors in accordance with a transmit mode or a receive mode of the antenna system (20).

9. The antenna system of any of claims 1 to 8, wherein the receive amplifier (30) and the transmit amplifier (40) each comprise a plurality of tuning elements (121, 122, 123, 124, 125) coupled to transmission lines.

10. The antenna system of claim 9, wherein one or more of the tuning elements (121, 122, 123, 124, 125) are configured to be tunable to adjust impedance of the amplifiers.

11. The antenna system of claim 9, wherein one or more of the tuning elements (121, 122, 123, 124, 125) are configured to be operated as a quarter-wave shunt switch.

12. The antenna system of any of claims 1 to 11, wherein the receive amplifier (30) and the transmit amplifier (40) comprise a monolithic microwave integrated circuit component.

13. The antenna system of any of claims 1 to 12, wherein the receive amplifier (30) is a low-noise amplifier, and the transmit amplifier (40) is a high-power amplifier.

14. The antenna system of any of claim 1 to 13, wherein:
the outputs of the receive amplifier (30) and transmit amplifier (40) each comprise an amplifier transistor;
the inputs (32, 42) of the receive amplifier (30) and transmit amplifier (40) each comprise a switch transistor (102);
a gate of the amplifier transistor of the receive amplifier (30) is coupled to an electrode of the switch transistor of the receive amplifier (30); and
a gate of the amplifier transistor of the transmit amplifier (40) is coupled to an electrode of the switch transistor of the transmit amplifier.

15. The antenna system of claim 14 wherein the gates of the switch transistors are coupled to the system processor (100), which is configured to manipulate impedance of the amplifiers by sending control signals to the switch transistors in accordance with either a transmit mode and a receive mode of the antenna system (20).
